# EUROPEAN PATENT APPLICATION

(11) **EP 4 801 202 A1**
(43) Date of publication of application: **02.09.2026**
(21) Application number: 24884253.6
(22) Date of filing: 09.09.2024
(51) Int. Cl.: H05K 1/02, H05K 1/18

(54) **CURRENT CARRYING DEVICE AND PCB DEVICE**

(30) Priority: 31.10.2023 CN 202311434331
(71) Applicant: ZTE CORPORATION, Shenzhen, Guangdong 518057 (CN)
(72) Inventor: LU, Xian, Shenzhen, Guangdong 518057 (CN)
(74) Representative: Canzler & Bergmeier Patentanwälte Partnerschaft mbB
(86) International application number: PCT/CN2024/117708
(87) International publication number: WO 2025/092246

(57) **Abstract**

The present application discloses a current carrying device (10) and a PCB device. The current carrying device (10) is applied to a PCB (100), and comprises: a cable assembly (200), the cable assembly (200) comprising a plurality of cables (210) arranged side by side and insulated from each other, and the cable assembly (200) being arranged above the PCB (100); and two adapter assemblies (300) that are respectively connected to two ends of the cable assembly (200), two ends of the plurality of cables (210) being both connected to the corresponding adapter assemblies (300), and the two adapter assemblies (300) being used for connecting the cables (210) to the PCB (100).

## Description

### CROSS REFERENCE TO RELATED APPLICATIONS

The present disclosure claims the priority to Chinese Patent Application No. 202311434331.1 filed on October 31, 2023, the contents of which are incorporated herein by reference in their entirety.

### TECHNICAL FIELD

The present disclosure relates to the technical field of electronic components, and in particular, to a current carrying device and a PCB (Printed Circuit Board) device.

### BACKGROUND

A PCB is an important electronic part, and serves as support for electronic components and a carrier for electrical connections of the electronic components. The PCB is called the "printed" circuit board because the PCB is manufactured by electronic printing technology.

In a case where the PCB fails to meet current carrying expectations due to a too large current from a power supply, the current carrying expectations can be met only by increasing the number of stacked layers of the PCB. However, cost for increasing the number of stacked layers of the PCB is relatively high, and for some PCBs, the number of stacked layers cannot be increased infinitely due to thickness limitation.

### SUMMARY

The present disclosure provides a current carrying device for a PCB, including: a cable assembly, including a plurality of cables disposed side by side and insulated from each other, the cable assembly being disposed above the PCB; and two adapter assemblies respectively connected to two ends of the cable assembly, two ends of each of the plurality of cables being correspondingly connected to the adapter assemblies, and the two adapter assemblies being configured to connect the cable assembly to the PCB.

The present disclosure further provides a PCB device, including a PCB and the current carrying device described above, the PCB includes a stacked structure formed by stacking along a preset direction, and the stacked structure is provided with a layout surface facing the preset direction; the stacked structure includes a power supply layer, and the layout surface is provided with a power supply copper foil connected to the power supply layer; and the stacked structure further includes a ground layer stacked on a side of the power supply layer, and the layout surface is provided with a reference ground copper foil connected to the ground layer.

Other objectives and features of the present disclosure will become apparent upon reading the description, claims, and drawings of the present disclosure.

### BRIEF DESCRIPTION OF DRAWINGS

The above and/or additional aspects and advantages of the present disclosure will become apparent and readily understandable from the following description of implementations with reference to the drawings. In the drawings:
FIG. 1 is a schematic structural diagram of a current carrying device according to the related technology.
FIG. 2 is a schematic structural diagram of a current carrying device according to an implementation of the present disclosure.
FIG. 3 is a top view of a current carrying device according to an implementation of the present disclosure.
FIG. 4 is a top view illustrating a connection between an adapter assembly and a cable assembly in a current carrying device according to an implementation of the present disclosure.
FIG. 5 is an axial view illustrating a connection between an adapter assembly and a cable assembly in a current carrying device according to an implementation of the present disclosure.
FIG. 6 is a side view illustrating a connection between an adapter assembly and a cable assembly in a current carrying device according to an implementation of the present disclosure.
FIG. 7 is a bottom view illustrating a connection between an adapter assembly and a cable assembly in a current carrying device according to an implementation of the present disclosure.
FIG. 8 is a top view of a PCB equipped with a current carrying device according to an implementation of the present disclosure.
FIG. 9 is a bottom view of an adapter assembly in a current carrying device according to an implementation of the present disclosure.

Main reference numerals:
1, current carrying device; 2, current carrying strip; 3, PCB;
10, current carrying device; 100, PCB; 110, layout surface; 120, connection hole;
130, power supply copper foil; 140, reference ground copper foil;
200, cable assembly; 210, cable; 300, adapter assembly; 310, housing;
311, first opening; 320, first connection structure; 321, protrusion;
330, second connection structure; 331, arc-shaped spring leaf;
340, third connection structure; 341, connector; 342, arc-shaped spring leaf.

### DETAIL DESCRIPTION OF EMBODIMENTS

The implementations of embodiments of the present disclosure will be described in detail below, the examples of the implementations are illustrated by the drawings, and the same or similar reference numerals refer to the same or similar elements or elements having the same or similar functions throughout the present disclosure. The implementations described below with reference to the drawings are illustratively and merely used to explain the present disclosure, and should not be interpreted as limiting the present disclosure.

In the description of the present disclosure, it should be understood that the orientations or positional relationships indicated by the terms "center", "longitudinal", "lateral", "length", "width", "thickness", "above", "below", "front", "behind", "left", "right", "vertical", "horizontal", "top", "bottom", "inner", "outer", "clockwise", "counterclockwise" and the like are the orientations or positional relationships based on the drawings, and are used just for conveniently describing the present disclosure and simplifying the description, rather than indicating or implying that the device or element referred by the terms must have a particular orientation or must be constructed and operated in a particular orientation, and therefore, the terms should not be considered as limitation to the present disclosure. In addition, the terms "first" and "second" are used just for the purpose of description, and should not be interpreted as indicating or implying relative importance or implicitly indicating the number of the technical features referred by the terms. Thus, any feature defined by "first" or "second" may explicitly or implicitly include one or more features. In the description of the present disclosure, unless explicitly limited otherwise, "a plurality of" means two or more.

In the description of the present disclosure, unless expressly stated and limited otherwise, the terms "mount", "couple", and "connect" should be understood broadly, for example, the terms may refer to fixed connection, detachable connection, or integration; the terms may refer to mechanic connection, electrical connection, or mutual communication; and the terms may refer to direct connection, indirect connection through an intermediate medium, communication between interiors of two elements, or an interaction relationship between two elements. The particular meanings of the above terms in the present disclosure can be understood by those of ordinary skill in the art according to particular conditions.

A plurality of different implementations or examples are given below for implementing different structures of the present disclosure. For simplifying the present disclosure, components and configurations in paticular examples are described below. Certainly, the components and configurations are just for illustration and are not intended to limit the present disclosure. In addition, the reference numerals and/or reference signs may be repeated in different examples of the present disclosure, and the repetition is for the purpose of simplicity and clarity, and does not indicate a relationship between the discussed implementations and/or configurations. Moreover, examples of particular processes and materials are provided herein, but those of ordinary skill in the art can envisage the application of other processes and/or the use of other materials.

In the Description, the reference terms such as "an implementation", "some implementations", "an exemplary implementation", "an example", "a particular example" and "some examples" indicate that the features, structures, materials or characteristics particularly described in conjunction with the implementation(s) or example(s) are included in at least one implementation or example of the present disclosure. In the Description, the illustrative descriptions of the above terms do not necessarily refer to the same implementation(s) or example(s). Moreover, the features, structures, materials or characteristics described may be combined in any suitable way in any one or more implementations or examples.

In a case where a PCB fails to meet current carrying expectations due to a too large current from a power supply, the current carrying expectations can be met only by increasing the number of stacked layers of the PCB. However, cost for increasing the number of stacked layers of the PCB is relatively high, and for some PCBs, the number of stacked layers cannot be increased infinitely due to thickness limitation. In view of the above, how to meet the current carrying expectations without increasing the number of layers of the PCB is an urgent problem to be solved.

In order to solve the above technical problem, it is proposed in the related technology to dispose a surface-mounted auxiliary component on a surface layer of a PCB to carry current. The surface-mounted auxiliary component may adopt a structure of a current carrying block or a current carrying strip.

A relative positional relationship between the surface-mounted auxiliary component, such as the current carrying block or the current carrying strip, and the PCB is described below by taking the surface-mounted auxiliary component being the current carrying strip as an example.

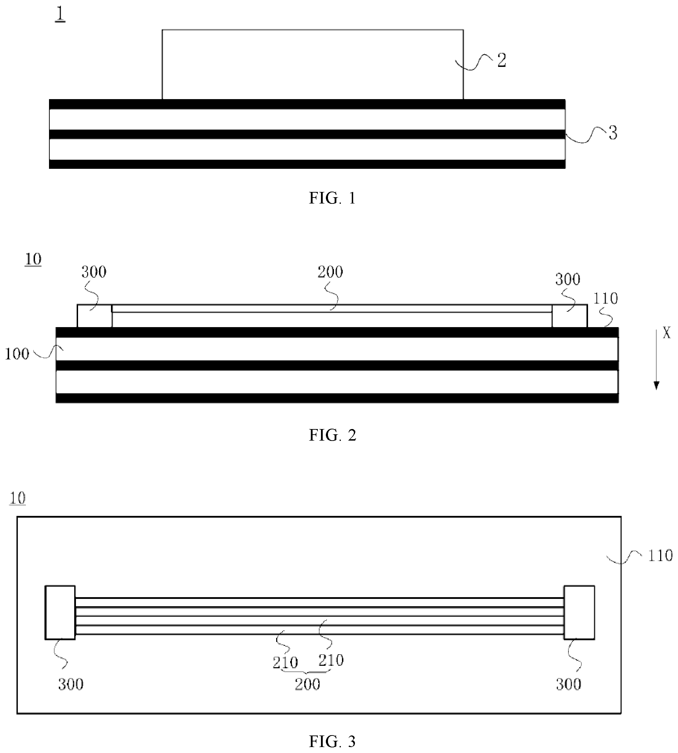

FIG. 1 is a schematic structural diagram of a current carrying device 1 for a PCB 3 according to the related technology. Referring to FIG. 1, the current carrying device 1 includes a current carrying strip 2; and the current carrying strip 2 is attached to the PCB 3, and thus the current carrying strip 2 is called a surface-attached auxiliary component. In practical applications of the current carrying device 1 shown in FIG. 1, the current carrying strip 2 is fixedly connected to a surface copper foil of the PCB 3. A fixed connection between the current carrying strip 2 and the PCB 3 may be a welded or screw connection, and other fixed connection may also be adopted. The current carrying strip 2 can perform current carrying, thereby relieving current carrying pressure of the PCB.

However, in the current carrying device 1 provided in the related technology, since the current carrying strip 2 is attached to a surface layer of the PCB 3, a large amount of surface space of the PCB 3 is occupied, and layout of components on the surface layer of the PCB 3 is affected.

Operation of each chip on the PCB relies on functions of various power supply networks. As competition in the electronic product market intensifies, expectations on controlling the cost of the PCB are gradually rising, the number of layers of the PCB is reduced, and the space for the power supply networks becomes scarce. With continuous increase in operating current of the chips, current carrying capacity of the PCB gradually becomes a concern in designing the power supply networks. In response to current carrying expectations of the PCB being met, how to make full use of the surface layer of the PCB and the space above the surface layer of the PCB to reduce losses of the power supply networks during current transmission cannot be ignored.

In order to solve the above technical problem in the related technology, an embodiment of the present disclosure proposes a current carrying device 10 for a PCB 100, the current carrying device 10 includes a cable assembly 200 and two adapter assemblies 300. The cable assembly 200 performs current carrying to bear part of a current in the PCB 100 for relieving current carrying pressure of the PCB 100, and the adapter assemblies 300 located at two ends of the cable assembly 200 implement a connection between the cable assembly 200 and the PCB 100, thereby meeting current carrying expectations of the PCB 100 without increasing the number of layers of the PCB 100. Moreover, since the adapter assemblies 300 are respectively disposed at two ends of the cable assembly 200, the cable assembly 200 can be connected to the PCB 100 without being attached to a layout surface 110 of the PCB 100, that is, there is a gap between the cable assembly 200 and the layout surface 110 of the PCB 100. Thus, the cable assembly 200 can be prevented from affecting arrangement of components on the layout surface 110 of the PCB 100, and full utilization of the surface layer of the PCB and the space above the surface layer of the PCB can be realized during designing the PCB 100, so as to reduce losses of power supply networks during current transmission, thereby solving the technical problem in the related technology.

In order to better explain the embodiment of the present disclosure and particular implementations, the present disclosure is described below with reference to the drawings. It should be noted that the structures shown in the drawings are merely illustrative and do not constitute any limitation to the structures in the embodiment, and other structures derived are also within the scope of the present disclosure. FIG. 2 is a schematic structural diagram of the current carrying device 10 according to an implementation of the present disclosure. FIG. 3 is a top view of the current carrying device 10 according to an implementation of the present disclosure. Referring to FIG. 2 and FIG. 3, the current carrying device 10 includes the cable assembly 200 and the two adapter assemblies 300. The PCB 100 includes a stacked structure, the stacked structure is formed by stacking along a preset direction, and the preset direction may be an X direction shown in FIG. 2. It should be noted that the preset direction may alternatively be an opposite direction of the X direction.

It should be noted that the stacked structure can be understood as that the PCB 100 includes a multi-layer circuit board that is formed by stacking, the multi-layer circuit board includes at least three conductive layers, two of the at least three conductive layers are on outer sides, and the remaining one or ones are combined in an insulation board. Electrical connections between the conductive layers are generally realized with plated through holes in a cross-section of the circuit board. Unless otherwise stated, like a double-sided board, a multi-layer printed circuit board is typically a board with plated through holes. The multi-layer circuit board is manufactured by stacking two or more layers of circuits, with the two or more layers of circuits being reliably connected to each other with a preset connection.

In some implementations, the stacked structure may include a top layer, a power supply layer, a ground layer, and a bottom layer, which are stacked along the preset direction. Certainly, the stacked structure may further include other layer structures, and the number of layers of either the top layer, the power supply layer, the ground layer, or the ground layer may be one or two. The number of layers and particular structures of the layers of the stacked structure are not limited herein.

Referring to FIG. 2 and FIG. 3, the stacked structure has the layout surface 110 facing the preset direction, the PCB 100 may have components disposed on the layout surface 110, and the layout surface 110 may be understood as the surface layer of the PCB 100.

Referring to FIG. 3, the cable assembly 200 may include a plurality of cables 210 disposed side by side and insulated from each other, the plurality of cables 210 are sequentially disposed side by side along an arrangement direction, the arrangement direction may be parallel to the layout surface 110, that is, the plurality of cables 210 are disposed side by side in a plane parallel to the layout surface 110. It should be noted that the cable 210 includes a conductor and an insulation layer covering the conductor, and the conductor may be made of copper or copper-tin alloy. A structure of the cable 210 is fully disclosed in the related technology, and thus will not be described in detail here. The plurality of cables 210 shown in FIG. 3 being insulated from each other can be understood as that conductors of the cables 210 are insulated from each other through insulation layers.

The cable assembly 200 is disposed above the PCB 100. In particular, the cable assembly 200 is disposed above the layout surface 110, with reference to a relative positional relationship between the cable assembly 200 and the layout surface 110 shown in FIG. 2. It should be noted that the cable assembly 200 is not attached to the layout surface 110, and it can be understood that the cable assembly 200 is "suspended" above the layout surface 110. Thus, components can be disposed between the cable assembly 200 and the layout surface 110, so that an influence of the presence of the cable assembly 200 on the arrangement of components on the layout surface 110 can be avoided, and full utilization of the surface layer of the PCB and the space above the surface layer of the PCB can be realized during designing the PCB 100, thereby reducing the losses of the power supply networks during current transmission.

Referring to FIG. 2 and FIG. 3, the two adapter assemblies 300 are respectively connected to two ends of the cable assembly 200, in other words, two ends of the cable assembly 200 are respectively provided with the adapter assemblies 300. The cable assembly 200 includes the plurality of cables 210, and two ends of each of the plurality of cables 210 are correspondingly connected to the adapter assemblies 300. The two adapter assemblies 300 may be connected to the PCB 100, and thus connect the cables 210 to the PCB 100 to enable the cable assembly 200 to carry current.

In the current carrying device 10 provided in the embodiment, the plurality of cables 210 of the cable assembly 200 perform current carrying to bear part of the current in the PCB 100 for relieving the current carrying pressure of the PCB 100, and the adapter assemblies 300 located at two ends of the cable assembly 200 implement a connection between the cable assembly 200 and the PCB 100, so that the current carrying expectations of the PCB 100 can be met without increasing the number of layers of the PCB 100. Moreover, since the adapter assemblies 300 are respectively disposed at two ends of the cable assembly 200, the cable assembly 200 can be connected to the PCB 100 without being attached to the layout surface 110 of the PCB 100, that is, there is a gap between the cable assembly 200 and the layout surface 110 of the PCB 100. Thus, the cable assembly 200 can be prevented from affecting the arrangement of components on the layout surface 110 of the PCB 100.

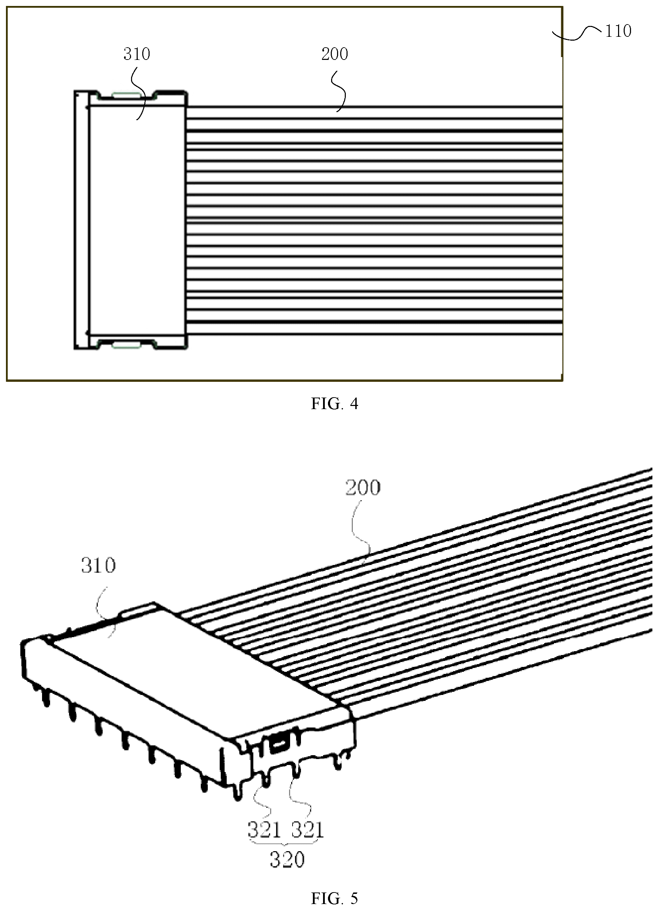

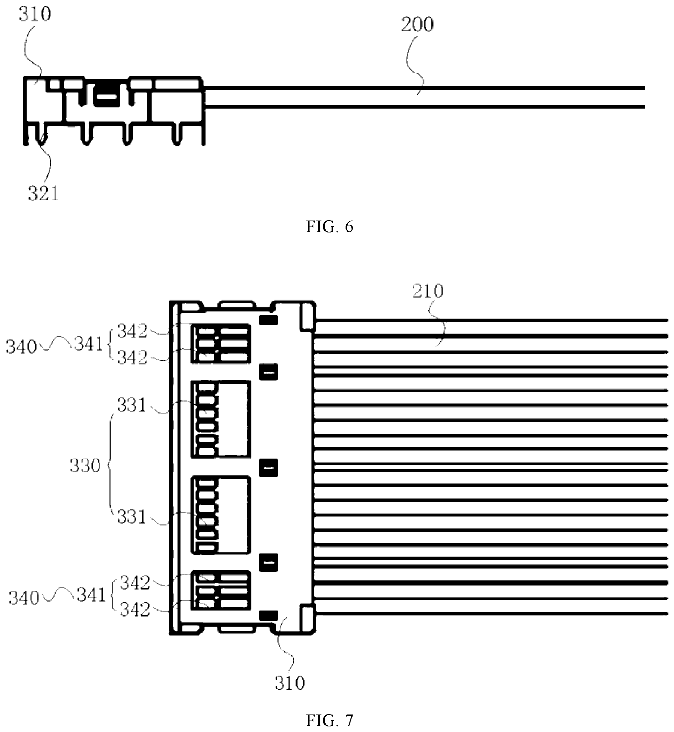

FIG. 4 is a top view illustrating a connection between the adapter assembly 300 and the cable assembly 200 in the current carrying device 10 according to an implementation of the present disclosure. FIG. 5 is an axial view illustrating a connection between the adapter assembly 300 and the cable assembly 200 in the current carrying device 10 according to an implementation of the present disclosure. FIG. 6 is a side view illustrating a connection between the adapter assembly 300 and the cable assembly 200 in the current carrying device 10 according to an implementation of the present disclosure. Referring to FIG. 4 to FIG. 6, the adapter assembly 300 includes a housing 310 and a first connection structure 320, and the first connection structure 320 may be connected to the housing 310, for example, the first connection structure 320 may be electrically connected to the housing 310 or connected to but insulated from the housing 310. The first connection structure 320 is configured to be fixedly connected to the PCB 100.

The PCB 100 is provided with a connection hole having an opening at the layout surface 110, and the connection hole penetrates through at least one layer of the stacked structure, for example, the connection hole may penetrate through one layer, two layer s, three layers, four layers, or all layers in the stacked structure. In some implementations, in order to facilitate manufacturing the connection hole in the PCB 100 and realize good versatility of the connection hole without requiring an adaptive change based on a length of the first connection structure 320, the connection hole may penetrate through all layers in the stacked structure, that is, the connection hole is disposed as a structure of a through hole in the PCB 100.

In some implementations, the first connection structure 320 is disposed in the connection hole to be fixedly connected to the PCB 100. The fixed connection between the first connection structure 320 and the PCB 100 may be realized by welding or through other connection structures.

In some implementations, referring to FIG. 6, the first connection structure 320 may include a plurality of protrusions 321 configured to be welded to the PCB 100. The protrusions 321 are disposed at equal or unequal intervals. The protrusions 321 each extend along a direction from the housing 310 towards the PCB 100, so as to be inserted into the connection holes; and axes of the connection holes are perpendicular to the layout surface 110.

The PCB 100 is provided with a plurality of connection holes, and the plurality of protrusions 321 and the plurality of connection holes are the same in number and are disposed in one-to-one correspondence, so that each protrusion 321 can be connected to the PCB 100, which improves reliability of connections between the adapter assemblies 300 and the PCB 100.

During fixedly connecting the PCB 100 to the current carrying device 10, the protrusions 321 are inserted into the connection holes and welded to the connection holes, that is, the first connection structure 320 is disposed in the connection holes and welded to inner walls of the connection holes, thereby achieving a welded connection between the first connection structure 320 and the PCB 100.

In some implementations, the protrusions 321 are directly welded to the PCB 100.

In the current carrying device 10 provided in the embodiment, the connections between the adapter assemblies 300 and the PCB are implemented by cooperation between the first connection structure 320 and the connection holes; since the cable assembly 200 is fixedly connected to the adapter assemblies 300, the cable assembly 200 and the adapter assemblies 300 can be prevented from shaking on the PCB 100, and firmness of the cable assembly 200 and the adapter assemblies 300 on the PCB 100 can be improved.

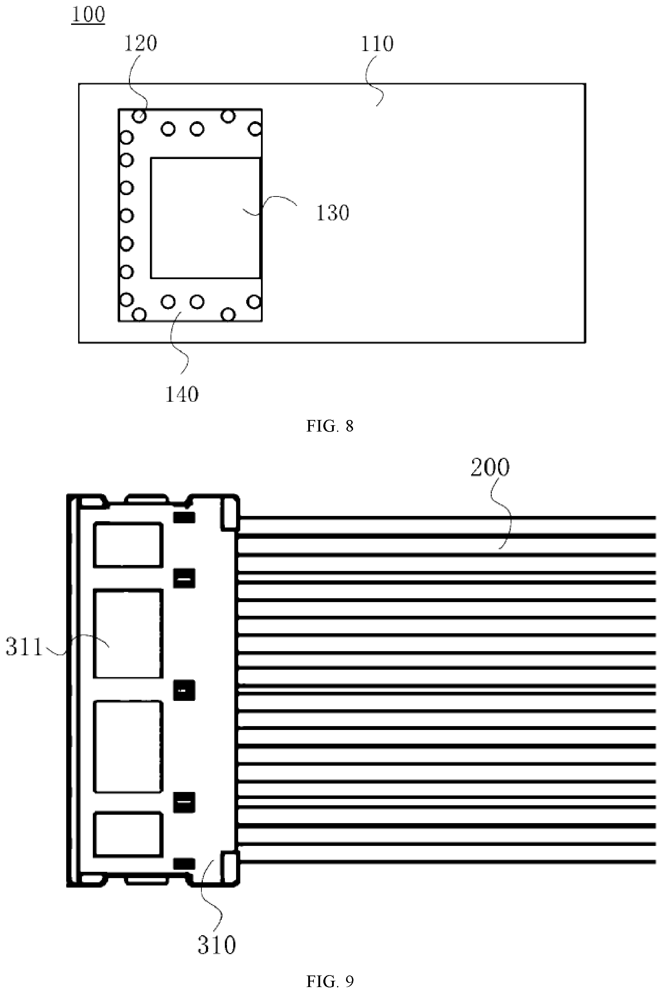

FIG. 7 is a bottom view illustrating a connection between the adapter assembly 300 and the cable assembly 200 in the current carrying device 10 according to an implementation of the present disclosure. FIG. 8 is a top view of the PCB 100 equipped with the current carrying device 10 according to an implementation of the present disclosure. Referring to FIG. 7 and FIG. 8, the housing 310 has an accommodation cavity, and the adapter assembly 300 further includes a second connection structure 330 disposed in the accommodation cavity. The second connection structure 330 is configured to implement a power supply connection between the cables 210 and the PCB 100.

The second connection structure 330 may be connected to and insulated from an inner wall of the housing 310, for example, an insulation material is disposed between the second connection structure 330 and the inner wall of the housing 310, the second connection structure 330 is connected to the insulation material, and the insulation material is connected to the inner wall of the housing 310, thereby achieving an insulated connection between the second connection structure 330 and the inner wall of the housing 310. The second connection structure 330 is electrically connected to partial ones of the cables 210 of the cable assembly 200, and the cables 210 may be connected to the second connection structure 330 through connection structures.

The stacked structure includes the power supply layer, the layout surface 110 is provided with a power supply copper foil 130 connected to the power supply layer, and the power supply copper foil 130 may be connected to the power supply layer through a via.

The second connection structure 330 and the power supply copper foil 130 are configured to be in contact with each other in response to the first connection structure 320 being connected to the PCB 100, thereby achieving a contact connection between the second connection structure 330 and the power supply copper foil 130.

FIG. 9 is a bottom view of the adapter assembly 300 in the current carrying device 10 according to an implementation of the present disclosure. Referring to FIG. 9, in some implementations, the housing 310 may be provided with a through hole penetrating through a wall of the housing 310 in a direction in which a thickness of the wall extends, the through hole has a first opening 311 formed at an outer surface of the wall of the housing 310, the first opening 311 faces the layout surface 110, and at least part of the second connection structure 330 may protrude out of the accommodation cavity from the first opening 311 to be connected with the power supply copper foil 130 in contact. In some implementations, a top cover (not provided with the first opening 311 and facing the layout surface 110 of the PCB 100) of the housing 310 may be made of an insulation material.

In order to reduce resistances of the adapter assemblies 300 in connections, the second connection structure 330 may be made of a material of copper.

In some implementations, the second connection structure 330 includes a plurality of arc-shaped spring leaves 331 insulated from each other, and the arc-shaped spring leaves 331 each are in a shape of a circular arc. The arc-shaped spring leaves 331 and the cables 210 connected to the second connection structure 330 are the same in number and are connected in one-to-one correspondence, in other words, each cable 210 is individually connected to one arc-shaped spring leaf 331. The arc-shaped spring leaves 331 are configured to implement a power supply connection between each cable 210 and the PCB 100, thereby enabling the cables 210 to shunt current.

In order to reduce the resistances of the adapter assemblies 300 in connections, the arc-shaped spring leaves 331 may be made of a material of copper.

Referring to FIG. 7 and FIG. 8, the adapter assembly 300 may further include a third connection structure 340 disposed in the accommodation cavity. The third connection structure 340 is configured to implement a return current connection between the cables 210 and the PCB 100.

The third connection structure 340 may be electrically connected to the inner wall of the housing 310. For example, the third connection structure 340 is welded to the inner wall of the housing 310 through a conductive material, thereby achieving an electrical connection between the third connection structure 340 and the inner wall of the housing 310. The third connection structure 340 is electrically connected to the remaining cables 210 of the cable assembly 200, and the housing 310 is electrically connected to the first connection structure 320, in other words, the third connection structure 340 is electrically connected to the first connection structure 320 and the remaining cables 210 of the cable assembly 200.

The stacked structure may further include the ground layer, and the ground layer is stacked on a side of the power supply layer, for example, the ground layer is disposed on the power supply layer along the preset direction shown in FIG. 1, or disposed under the power supply layer along the preset direction shown in FIG. 1. The layout surface 110 is provided with a reference ground copper foil 140 connected to the ground layer, and the reference ground copper foil 140 may be connected to the ground layer through a via.

Referring to FIG. 8, in some implementations, openings of the connection holes are located at the reference ground copper foil 140. The third connection structure 340 and the reference ground copper foil 140 are in contact with each other in response to the first connection structure 320 being connected to the PCB 100, thereby achieving a contact connection between the third connection structure 340 and the reference ground copper foil 140.

Similarly, referring to FIG. 9, in some implementations, the housing 310 may be provided with the through hole penetrating through the wall of the housing 310 in a direction in which a thickness of the wall extends, the through hole has the first opening 311 formed at the outer surface of the wall of the housing 310, the first opening 311 faces the layout surface 110, and at least part of the third connection structure 340 may protrude out of the accommodation cavity from the first opening 311 to be connected with the reference ground copper foil 140 in contact.

In order to reduce the resistances of the adapter assemblies 300 in connections, the third connection structure 340 may be made of a material of copper.

In some implementations, the third connection structure 340 includes a plurality of arc-shaped spring leaves 342 insulated from each other, and the arc-shaped spring leaves 342 each are in a shape of a circular arc. The arc-shaped spring leaves 342 and the cables 210 connected to the third connection structure 340 are the same in number and are connected in one-to-one correspondence, in other words, each cable 210 is individually connected to one arc-shaped spring leaf 342. The arc-shaped spring leaves 342 are configured to implement a power supply connection between each cable 210 and the PCB 100, thereby enabling the cables 210 to shunt current.

In order to reduce the resistances of the adapter assemblies 300 in connections, the arc-shaped spring leaves 342 may be made of a material of copper.

In some implementations, the arc-shaped spring leaves 331 of the second connection structure 330 and the arc-shaped spring leaves 342 of the third connection structure 340 may adopt a same structure.

In some implementations, the third connection structure 340 includes a connector 341 including a plurality of arc-shaped spring leaves 342, and the connector 341 is disposed on a side of the second connection structure 330. For example, the connector 341 may be disposed on a left side of the second connection structure 330. Alternatively, the connector 341 may be disposed on a right side of the second connection structure 330.

In some implementations, the third connection structure 340 includes a plurality of connectors 341, each connector 341 includes a plurality of arc-shaped spring leaves 342, and the plurality of connectors 341 are respectively disposed on two sides of the second connection structure 330.

Referring to FIG. 7, in some implementations, the third connection structure 340 may include two connectors 341, each connector 341 includes a plurality of arc-shaped spring leaves 342, and the two connectors 341 are respectively disposed on two sides of the second connection structure 330. For example, each connector 341 may include six arc-shaped spring leaves 342.

It should be noted that the number and type of the cables 210 of the cable assembly 200 are related to the PCB 100, and different numbers and types may be adopted in different implementations. However, operations for determining the number and type of the cables 210 of the cable assembly 200 are the same in the different implementations. For ease of understanding, a particular implementation of designing and manufacturing the current carrying device 10 is described in detail below.

Firstly, a simulation of the PCB 100 is performed.

Based on expectations on a design of the PCB 100, a simulation of the PCB 100 is performed through a simulation device. In response to a result of the simulation shows that current flowing in a power plane of the PCB 100 fails to meet the expectations and a power consumption of the PCB 100 is too large, a current shunt operation is to be performed on the PCB 100, so as to enable current flowing in the PCB 100 to meet the expectations.

In the related technology, the above problem is solved by increasing the number of power supply layers or by providing a surface-mounted auxiliary component, but the PCB 100 is thickened in response to increasing the number of power supply layers, which may make the PCB 100 hard to be mounted in a designated space, and thus affect an application of the PCB 100; and the surface-mounted auxiliary component may affect a layout on a surface of the PCB 100.

The embodiment proposes a technical solution different from those in the related technology to solve the above technical problem. According to the embodiment, the cable assembly 200 performs current carrying to bear part of the current in the PCB 100 for relieving the current carrying pressure of the PCB 100, and the adapter assemblies 300 located on two ends of the cable assembly 200 implement the connection between the cable assembly 200 and the PCB 100, so that the current carrying expectations of the PCB 100 can be met without increasing the number of layers of the PCB 100. Moreover, since the cables 210 do not have fixed shapes and are flexible, the cables 210 are not to be attached to the layout surface 110 of the PCB 100, resulting in relatively high flexibility in practical applications.

Secondly, the number and type of the cables 210 for assisting in current carrying are calculated and simulated.

At operation 1, the number of power supply layers included in the stacked structure of the PCB 100 is acquired, and then a maximum current-carrying capacity I_{pcb} of the PCB 100 is obtained by a calculation based on the number of power supply layers of the PCB 100.

At operation 2, an actual operating current Iₜₒₜₐₗ of a chip on the PCB 100 is acquired, and a difference ΔI ( ΔI = Iₜₒₜₐₗ - I_{pcb} ) between the actual operating current Iₜₒₜₐₗ of the chip and the maximum current-carrying capacity I_{pcb} of the PCB 100 is then calculated. The difference ΔI can be understood as a value of a current to be carried by the cable assembly 200.

At operation 3, based on the difference ΔI and conditions for temperature rising, a proper type of cables 210 are selected, and the number of the cables 210 of the cable assembly 200 is determined.

At operation 4, a direct current resistance R_{pcb} of the power supply layers in the PCB 100 is obtained by a simulation.

At operation 5, a total direct current resistance R_{cable} of the cable assembly 200 and the adapter assemblies 300 is calculated.

At operation 6, a current I_{cable} which can be actually carried by the cable assembly 200 is calculated based on a current division principle.${I}_{pcb} / {I}_{cable} = {R}_{cable} / {R}_{pcb}$

At operation 7, the current I_{cable} which can be actually carried by the cable assembly 200 is compared with the current ΔI to be carried by the cable assembly 200, if I_{cable}>ΔI, the design of the cable assembly 200 (which at least involves the number of the cables 210 of the cable assembly 200 and the type of the cables 210) is proper; if I_{cable}<ΔI, an auxiliary current-carrying capacity of the cable assembly 200 cannot meet the current carrying expectations of the PCB 100, and in this case, the number of cables 210 of the cable assembly 200 is desired to be increased or the direct current resistance R_{cable} of the cables 210 and the adapter assemblies 300 is desired to be reduced for improving the actual current-carrying capacity I_{cable} of the cables 210.

At operation 8, the PCB 100 at least including the stacked structure and a via is manufactured.

At operation 9, a simulation is performed through the simulation device to verify whether the power consumption of the PCB 100 equipped with the current carrying device 10 meets the expectations after the cable assembly 200 is used to perform current carrying, and whether a magnitude of a shunted current of the cable assembly 200 is appropriate.

At operation 10, in response to a result of the simulation indicating that the expectations are met, the cable assembly 200 and the adapter assemblies 300 are manufactured, and the PCB 100 manufactured at operation 8, the cable assembly 200, and the adapter assemblies 300 are assembled to obtain the current carrying device 10.

In a comparative example, a current at the chip is set to be 500 A, then a total power consumption obtained by the simulation is 118.8 W.

In an implementation of the embodiment, a current at the chip is set to be 500 A, then a total power consumption obtained by the simulation is 97.1 W.

**Table 1**

| | voltage drop | power consumption | current carried by PCB 100 |
|---|---|---|---|
| PCB 100 alone (comparative example) | 236 mV | 118.8 W | 500 A |
| current carrying device 10: PCB 100+cable assembly 200+adapter assemblies 300 (implementation of embodiment) | 211 mV | 97.1 W | 392 A |
| improvement percentage | 10.6% | 18.3% | 21.6% |

Table 1 illustrates simulation results of the comparative example and the implementation of the embodiment.

As can be seen from the above simulation results, by adopting the cable assembly 200 and the adapter assemblies 300 described in the present disclosure, the total voltage drop is reduced by 10.6%, the power consumption of the PCB 100 is reduced by 18.3%, the current carried by the PCB 100 is reduced by 21.6%. Thus, both the current carrying situation and the power consumption of the PCB 100 are greatly improved.

An embodiment of the present disclosure further provides a PCB device including a PCB 100 and a current carrying device 10. The PCB 100 includes a stacked structure formed by stacking along a preset direction, and the stacked structure has a layout surfac e 110 facing the preset direction. The stacked structure includes a power supply layer, and the layout surface 110 is provided with a power supply copper foil 130 connected to the power supply layer. The stacked structure further includes a ground layer stacked on a side of the power supply layer, and the layout surface 110 is provided with a reference ground copper foil 140 connected to the ground layer.

The PCB 100 is provided with a connection hole 120 having an opening, the opening is located at the layout surface 110 and penetrates through at least one layer of the stacked structure, and the opening of the connection hole 120 is formed at the reference ground copper foil 140, and is to be connected with adapter assemblies 300.

The connection hole 120 is to be connected with a first connection structure 320 to implement a fixed connection between the adapter assemblies 300 and the PCB 100.

It should be noted that the above comparative example and the above implementation of the embodiment are merely used to illustrate the beneficial effects of the present disclosure, rather than limiting the embodiments of the present disclosure, and the above implementation may be further optimized, which will not be described in detail here.

It should be understood that the above embodiments and implementations are merely exemplary embodiments and exemplary implementations adopted to illustrate the principle of the present disclosure, and the present disclosure is not limited thereto. Various modifications and improvements may be made by those of ordinary sill in the art without departing from the spirit and essence of the present disclosure, and those modifications and improvements are considered to fall within the scope of the present disclosure.

## Claims

1. A current carrying device for a Printed Circuit Board (PCB), comprising:
a cable assembly comprising a plurality of cables disposed side by side and insulated from each other, the cable assembly being disposed above the PCB; and
two adapter assemblies respectively connected to two ends of the cable assembly, two ends of each of the plurality of cables being connected to the adapter assemblies correspondingly, and the two adapter assemblies being configured to connect the cable assembly to the PCB.

2. The current carrying device of claim 1, wherein each of the two adapter assemblies comprises a housing and a first connection structure connected to the housing, and the first connection structure is configured to be fixedly connected to the PCB.

3. The current carrying device of claim 2, wherein the first connection structure comprises a plurality of protrusions disposed at intervals, the protrusions extend along a direction from the housing towards the PCB, and the protrusions are welded to the PCB to achieve a welded connection between the first connection structure and the PCB.

4. The current carrying device of claim 2 or 3, wherein each of the two adapter assemblies further comprises:
a second connection structure, the housing having an accommodation cavity, the second connection structure being disposed in the accommodation cavity, and the second connection structure being connected to but insulated from an inner wall of the housing and electrically connected to partial ones of the cables of the cable assembly;
wherein the second connection structure and a power supply copper foil of the PCB are in contact with each other in response to the first connection structure being connected to the PCB, and the second connection structure is configured to implement a power supply connection between the cables and the PCB.

5. The current carrying device of claim 4, wherein the second connection structure comprises a plurality of arc-shaped spring leaves insulated from each other, and the arc-shaped spring leaves and the cables connected to the second connection structure are the same in number and are connected in one-to-one correspondence.

6. The current carrying device of claim 4 or 5, wherein each of the two adapter assemblies further comprises:
a third connection structure disposed in the accommodation cavity, the third connection structure being electrically connected to the inner wall of the housing and remaining ones of the cables of the cable assembly, and the housing being electrically connected to the first connection structure;
wherein the third connection structure and a reference ground copper foil of the PCB are in contact with each other in response to the first connection structure being connected to the PCB, and the third connection structure is configured to implement a return current connection between the cables and the PCB.

7. The current carrying device of claim 6, wherein the third connection structure comprises a plurality of arc-shaped spring leaves insulated from each other, and the arc-shaped spring leaves and the cables connected to the third connection structure are the same in number and are connected in one-to-one correspondence.

8. The current carrying device of claim7, wherein
the third connection structure comprises a connector, the connector comprising a plurality of arc-shaped spring leaves and being disposed on a side of the second connection structure; or
the third connection structure comprises a plurality of connectors, each of the connectors comprising a plurality of arc-shaped spring leaves, the plurality of connectors being respectively disposed on two sides of the second connection structure.

9. A PCB device, comprising a PCB and the current carrying device of any one of claims 1 to 8;
wherein the PCB comprises a stacked structure formed by stacking along a preset direction and provided with a layout surface facing the preset direction;
the stacked structure comprises a power supply layer, and the layout surface is provided with a power supply copper foil connected to the power supply layer; and
the stacked structure further comprises a ground layer stacked on a side of the power supply layer, and the layout surface is provided with a reference ground copper foil connected to the ground layer.

10. The PCB device of claim 9, wherein
the PCB is provided with a connection hole having an opening, the opening being located at the layout surface and penetrating through at least one layer of the stacked structure, and the opening of the connection hole is formed at the reference ground copper foil, and is to be connected with the two adapter assemblies.
